(19) Europäisches Patentamt
European Patent Office
Office européen des brevets

(11) **EP 2 591 553 B1**

(12) **EUROPÄISCHE PATENTSCHRIFT**

(45) Veröffentlichungstag und Bekanntmachung des Hinweises auf die Patenterteilung:
**29.07.2015 Patentblatt 2015/31**

(21) Anmeldenummer: **11741529.9**

(22) Anmeldetag: **20.06.2011**

(51) Int Cl.:
**H03L 7/091** *(2006.01)*  **G01F 23/296** *(2006.01)*

(86) Internationale Anmeldenummer:
**PCT/EP2011/060204**

(87) Internationale Veröffentlichungsnummer:
**WO 2012/004116 (12.01.2012 Gazette 2012/02)**

(54) **VERFAHREN ZUR REGELUNG DER PHASE IN EINEM SCHWINGKREIS**

METHOD FOR REGULATING THE PHASE IN AN TUNED CIRCUIT

PROCÉDÉ DE RÉGULATION DE LA PHASE DANS UN CIRCUIT OSCILLANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.07.2010 DE 102010030982**

(43) Veröffentlichungstag der Anmeldung:
**15.05.2013 Patentblatt 2013/20**

(73) Patentinhaber: **Endress+Hauser GmbH+Co. KG 79689 Maulburg (DE)**

(72) Erfinder:
• **URBAN, Martin**
  **79541 Lörrach (DE)**
• **BRENGARTNER, Tobias**
  **79111 Freiburg (DE)**

(74) Vertreter: **Andres, Angelika Maria Endress+Hauser(DE)Holding, Patserve, Colmarer Strasse 6 79576 Weil am Rhein (DE)**

(56) Entgegenhaltungen:
**DE-A1- 10 237 931    DE-A1-102009 028 022
US-A1- 2005 073 454**

• **KASHMIRI S M ET AL: "Measuring the thermal diffusivity of CMOS chips", SENSORS, 2009 IEEE, IEEE, PISCATAWAY, NJ, USA, 25. Oktober 2009 (2009-10-25), Seiten 45-48, XP031618533, ISBN: 978-1-4244-4548-6**

**Beschreibung**

Die vorliegende Erfindung betrifft ein Verfahren zur Regelung einer Phasenverschiebung zwischen Sendesignal und Empfangssignal einer elektromechanischen Wandlereinheit in einem Schwingkreis auf einen vorgegebenen Wert. Die elektromechanische Wandlereinheit ist beispielsweise ein piezoelektrischer Antrieb, welcher eine schwingfähige Einheit zu mechanischen Schwingungen anregt. Ein derartiges Schwingsystem findet sich beispielsweise in vibronischen Füllstands- oder Durchflussmessgeräten.

Die Anregung von vibronischen Schwingsystemen, bestehend aus schwingfähiger Einheit und elektromechanischer Wandlereinheit, erfolgt meist mittels eines analogen Schwingkreises. Durch den Schwingkreis stellt sich die Schwingung mit der Frequenz ein, bei welcher die Phasenverschiebung zwischen Sendesignal und Empfangssignal der elektromechanischen Wandlereinheit die Schwingkreisbedingung erfüllt, d.h. zusammen mit den übrigen im Schwingkreis auftretenden Phasen ein natürliches Vielfaches von 360° ergibt. Die analogen Elektronikbauteile eines derartigen Schwingkreises sind speziell auf das jeweilige Schwingsystem, z.B. auf eine Schwinggabel mit bestimmter Geometrie, abgestimmt, sodass ein Schwingsystem nicht einfach durch ein anderes ersetzbar ist, ohne den Schwingkreis durch einen entsprechend angepassten zu ersetzen.

Ebenfalls bekannt sind Verfahren, bei welchen das Schwingsystem mittels einer so genannten PLL (Phase-Locked-Loop) zu Schwingungen bei einer bestimmten Phasenlage angeregt wird. Diese Regelschleife kann analog oder teilweise oder vollständig digital ausgeführt sein. Eine digitale PLL hat den Vorteil, dass sie an andere Schwingsysteme anpassbar ist. Nachteilig ist jedoch, dass zur Anregung mittels digitaler PLL ein erhöhter Stromverbrauch verbunden ist, da die Hardwareressourcen gegeben sein müssen.

Die Aufgabe der Erfindung besteht in der Bereitstellung eines Verfahrens der eingangs genannten Art, welches universell für verschiedene Schwingsysteme einsetzbar ist und dessen Umsetzung mit geringem Stromverbrauch möglich ist, sowie in der Bereitstellung einer Vorrichtung mit einem Schwingsystem, welche das Verfahren umsetzt.

Die Aufgabe wird dadurch gelöst, dass das Empfangssignal zu bezüglich des Sendesignals vorgegebenen diskreten Zeitpunkten abgetastet wird, dass die abgetasteten Spannungswerte jeweils mit einem Sollwert verglichen werden, welchen das Empfangssignal zu diesem Zeitpunkt annimmt, wenn die vorgegebene Phasenverschiebung vorliegt, und dass im Falle einer Abweichung eines Spannungswertes von dem Sollwert ausgehend von dem Vorzeichen der Abweichung die Frequenz des Sendesignals verringert oder erhöht wird. Das Sendesignal könnte man ebenso als Anregesignal bezeichnen.

Um die eingestellte vorgegebene Phasenverschiebung beizubehalten, bzw. um eine eventuell auftretende Abweichung zu korrigieren, wird die aktuelle Phasenverschiebung des Empfangssignals überwacht und gegebenenfalls korrigiert. Die Erfindung nutzt aus, dass neben dem Zusammenhang zwischen vorgegebener Phasenverschiebung und Schwingfrequenz auch ein Zusammenhang zwischen dem aktuellen Spannungswert des Empfangssignals und der Phasenverschiebung besteht. Stimmt die Phasenverschiebung zwischen Sende- und Empfangssignal mit der vorgegebenen Phasenverschiebung überein, kann ausgehend vom Sendesignal eine Aussage darüber getroffen werden, zu welchen Zeitpunkten das Empfangssignal Nulldurchgänge und Extrema aufweist. Weicht die vorliegende Phasenverschiebung von der vorgegebenen Phasenverschiebung ab, nimmt das Empfangssignal zu diesen Zeitpunkten Werte an, welche nicht den Sollwerten entsprechen, d.h. nicht Null und nicht maximal bzw. minimal sind. Ist die Phasenverschiebung beispielsweise geringer als die vorgegebene Phasenverschiebung, dann weist das Empfangssignal zum Zeitpunkt des eigentlichen ersten Nulldurchgangs einen positiven und zum Zeitpunkt des zweiten einen negativen Spannungswert auf. Aus dem Vergleich der gemessenen Spannungswerte des Empfangssignals mit den Sollwerten kann daher bestimmt werden, ob die Anregungsfrequenz verringert oder erhöht werden muss, um die vorgegebene Phasenverschiebung zu erreichen. Die Regelung der Phasenverschiebung bzw. der Frequenz erfolgt rein digital. Dies ermöglicht eine Platz sparende Ausführung der Elektronikeinheit bei der Anwendung in einem Messgerät. Weiterhin ist der digitale Schwingkreis individuell an das anzuregende Schwingsystem anpassbar und somit universell einsetzbar.

In einer ersten Ausgestaltung der erfindungsgemäßen Lösung wird die elektromechanische Wandlereinheit zu Beginn der Regelung mit einer Frequenz zu Schwingungen angeregt, bei welcher das Sendesignal zumindest näherungsweise die vorgegebene Phasenverschiebung zu dem Empfangssignal aufweist. Um die Phasenverschiebung zuverlässig regeln zu können muss die Phasenverschiebung eines Ausgangspunkts ungefähr der vorgegebenen Phasenverschiebung entsprechen. Hierzu wird die zugehörige Frequenz bevorzugt mittels eines Frequenzsuchlaufs - Sweep - aufgesucht und eingestellt. Die Durchführung eines Frequenzsuchlaufs ist in der bislang noch nicht veröffentlichten deutschen Patentanmeldung mit der Anmeldenummer 102009026685.2 beschrieben. Eine vorteilhafte Weiterbildung des dort beschriebenen Verfahrens findet sich in der bislang noch nicht veröffentlichten deutschen Patentanmeldung mit der Anmeldenummer 102009028022.7.

Gemäß einer Weiterbildung des erfindungsgemäßen Verfahrens wird die Abweichung der vorliegenden Phasenverschiebung von der vorgegebenen Phasenverschiebung quantitativ erfasst und die Frequenz entsprechend der quantitativen Abweichung erhöht oder verringert. Ist die Amplitude des Empfangssignals bekannt, lässt sich z.B. über den Spannungswert zu dem Zeitpunkt, zu welchem ein Empfangssignal der vorgegebenen Phasenverschiebung einen Extremwert annimmt, bestimmen, wie stark die Phasenverschiebung von der vorgegebenen Phasenverschiebung abweicht, bzw. der Wert der Phasenverschiebung bestimmen. Hieraus kann ungefähr ermittelt werden, wie stark die Frequenz korrigiert werden muss, um die vorgegebene Phasenverschiebung zu erhalten.

Gemäß einer Ausgestaltung der Erfindung wird innerhalb einer Schwingungsperiode mindestens ein Spannungswert abgetastet. Bevorzugt werden ein oder zwei Spannungswerte abgetastet. Ist die Amplitude des Empfangssignals konstant und bekannt, reicht das Abtasten eines Punktes pro Schwingungsperiode aus, um die Geschwindigkeit zu bestimmen, mit welcher gegebenenfalls nachzuregeln ist. Ändert sich die Amplitude des Empfangssignals sind hierzu mindestens zwei abgetastete Punkte pro Schwingungsperiode notwendig, bevorzugt ein potentieller Nulldurchgang und das potentielle Maximum des Empfangssignals.

Bei einer vorteilhaften Ausgestaltung des Verfahrens wird das Empfangssignal zu Zeitpunkten abgetastet, zu welchen das Empfangssignal bei Vorliegen der vorgegebenen Phasenverschiebung Nulldurchgänge aufweist. Es können ein Nulldurchgang pro Periode oder zwei Nulldurchgänge pro Periode abgetastet werden. In Anwendungen mit geringeren Anforderungen an die Schnelligkeit der Regelung ist es auch möglich, nicht in jeder Periode Punkte abzutasten.

Eine weitere Ausgestaltung des Verfahrens sieht vor, dass das Empfangssignal zu Zeitpunkten abgetastet wird, zu welchen das Empfangssignal bei Vorliegen der vorgegebenen Phasenverschiebung extremal ist. Mit anderen Worten entspricht der abgetastete Punkt dem Maximum oder dem Minimum des Empfangssignals, falls die aktuelle Phasenverschiebung zwischen Sendesignal und Empfangssignal der vorgegebenen Phasenverschiebung entspricht.

Gemäß einer Ausgestaltung des Verfahrens wird der zu einem Zeitpunkt, zu welchem das Empfangssignal bei Vorliegen der vorgegebenen Phasenverschiebung extremal ist, abgetastete Spannungswert mit dem zu einem Zeitpunkt, zu welchem das Empfangssignal bei Vorliegen der vorgegebenen Phasenverschiebung einen Nulldurchgang aufweist, abgetasteten Spannungswert verglichen, und aus dem Vergleich die Frequenz bestimmt, mit welcher nachgeregelt wird. Das Abtasten sowohl bei Nulldurchgängen, als auch bei Extremwerten, ist bei variierender Empfangsamplitude vorteilhaft, da so die bei einem Nulldurchgang gemessene Abweichung von Null in Relation zu der aktuellen Amplitude gesetzt werden kann. Hierdurch ist bestimmbar, wie stark die Frequenz nachgeregelt werden muss. Bei konstanter Amplitude des Empfangssignals genügt die Kenntnis über den Spannungswert im Nulldurchgang um zu bestimmen, wie stark nachgeregelt werden muss.

Weiterhin betrifft die Erfindung eine Vorrichtung zur Bestimmung und/oder Überwachung mindestens einer Prozessgröße, mit einer schwingfähigen Einheit, mit einer Antriebs-/Empfangseinheit, welche die schwingfähige Einheit zu mechanischen Schwingungen anregt und Schwingungen von dieser empfängt und in ein elektrisches Empfangssignal umwandelt, und mit einer Regel-/Auswerteeinheit, welche aus dem Empfangssignal ein Sendesignal für die Antriebs-/Empfangseinheit erzeugt, wobei die Frequenz des Sendesignals derart eingestellt ist, dass zwischen dem Sendesignal und dem Empfangssignal im Wesentlichen eine vorgegebene Phasenverschiebung vorliegt. Die Vorrichtung zeichnet sich dadurch aus, dass die Regel-/Auswerteeinheit derart ausgestaltet ist, dass sie die Phasenverschiebung zwischen Sendesignal und Empfangssignal auf den vorgegebenen Wert regelt, wobei die Regel-/Auswerteeinheit das Empfangssignal zu bezüglich des Sendesignals vorgegebenen diskreten Zeitpunkten abtastet, die abgetasteten Spannungswerte jeweils mit einem Sollwert vergleicht, welchen das Empfangssignal zu diesem Zeitpunkt annimmt, wenn die vorgegebene Phasenverschiebung vorliegt, und im Falle einer Abweichung ausgehend von dem Vorzeichen der Abweichung die Frequenz des Sendesignals verringert oder erhöht. Die Regelung der Phase ist digital implementiert, sodass die Regel-/Auswerteeinheit an verschiedene schwingfähige Einheiten und Anwendungen ohne Umgestaltung der Hardware anpassbar ist.

Die Erfindung wird anhand der nachfolgenden Figuren näher erläutert.

Fig. 1a-c zeigen ein typisches Sendesignal, zwei zu diesem jeweils phasenverschobene Empfangssignale und die Abtastzeitpunkte;

Fig. 2 zeigt ein Flussdiagramm des erfindungsgemäßen Verfahrens.

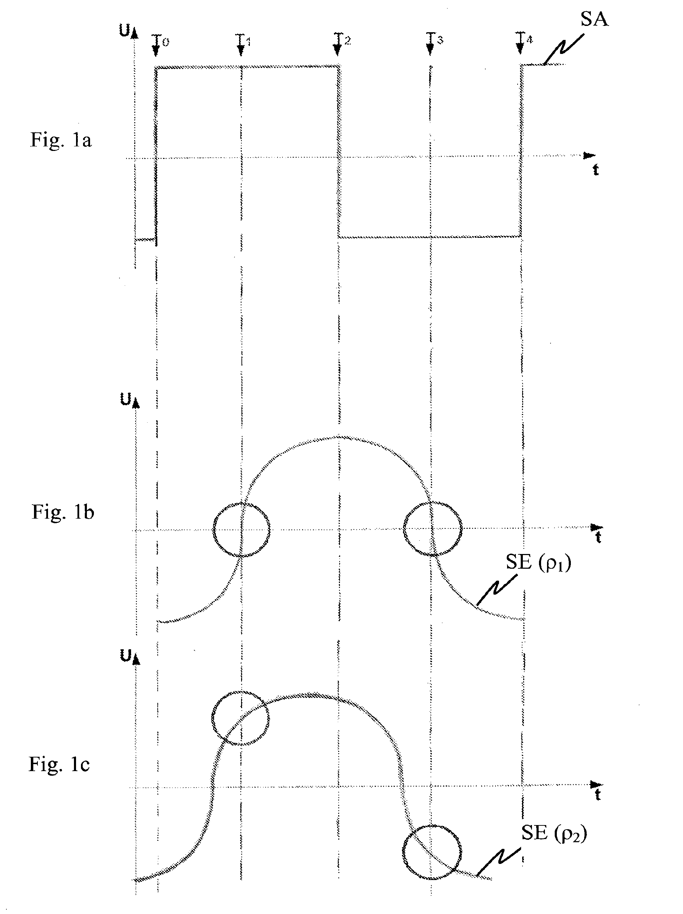

Fig. 1 a zeigt ein Sendesignal SA in Form einer Rechteckspannung. Fig.1b und 1c zeigen jeweils ein sinusförmiges Empfangssignal SE. Das in Fig. 1b dargestellte Empfangssignal weist relativ zum Sendesignal eine Phasenverschiebung $\rho_1$ von 90° auf. In Fig. 1c ist ein Empfangssignal mit einer von $\rho_1$ abweichenden Phasenverschiebung $\rho_2$ dargestellt.

Die dargestellten Zeitpunkte $T_i$ sind diejenigen auf das Sendesignal bezogenen Zeitpunkte, zu welchen das Empfangssignal abgetastet wird, d.h. zu welchen Nullstellen, Maxima oder Minima erwartet werden. Sie hängen von der vorgegebenen Phasenverschiebung p ab und ergeben sich bezüglich einer als Startwert gewählten Nullstelle $T_0$ des Sendesignals und der Periodendauer P des Sendesignals folgendermaßen:

$$T_i = T_0 + \frac{\rho + (i-1) \cdot 90°}{360°}.$$

$P$ wobei $i \in N$ und $1 \leq i \leq 4$

Für den dargestellten Fall wird angenommen, die vorgegebene Phasenverschiebung p sei 90°. Das Empfangssignal wird zumindest zu dem Zeitpunkt $T_1$ und/oder $T_3$ abgetastet, da zu diesen Zeitpunkten eine Nullstelle erwartet wird. Das in Fig. 1 b dargestellte Empfangssignal weist zu $T_1$ und $T_3$ tatsächlich Nullstellen auf, d.h. dessen Phasenverschiebung $\rho_1$ entspricht der vorgegebenen Phasenverschiebung $\rho = 90°$ und die Sendefrequenz ist korrekt eingestellt. Der Spannungswert des in Fig.1 c dargestellten Empfangssignals ist jedoch zum Zeitpunkt $T_1$ positiv und zum Zeitpunkt $T_3$ negativ. Mit anderen Worten befindet sich das Empfangssignal zu $T_1$ im Anstieg in Richtung des Maximums, d.h. die Nullstelle wurde bereits zu einem früheren Zeitpunkt durchlaufen. Hieraus folgt, dass die Phasenverschiebung $\rho_2$ dieses Empfangssignals geringer ist als 90°. Die Phasenverschiebung liegt für niedrige Frequenzen bei 0° und steigt für hohe Frequenzen auf 180°, wobei bei der Eigenfrequenz die geforderte Phasenverschiebung von 90° vorliegt. Um die geforderte Phasenverschiebung $\rho = 90°$ zu erreichen muss die Frequenz des Sendesignals daher erhöht werden.

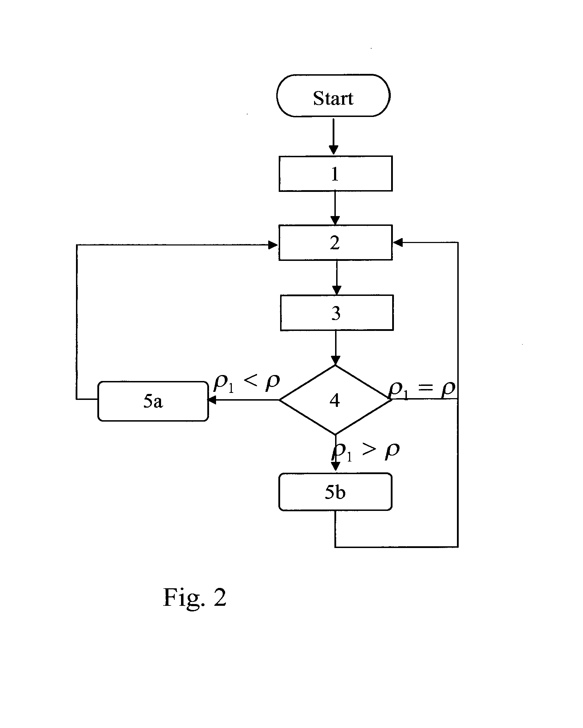

Fig. 2 zeigt ein Flussdiagramm einer bevorzugten Ausführung des erfindungsgemäßen Verfahrens. In Schritt 1 wird das Schwingsystem mittels eines Frequenzsweeps zu Schwingungen angeregt. Hierdurch wird die Frequenz für das Sendesignal eingestellt, welche der vorgegebenen Phasenverschiebung p entspricht, beispielsweise die Eigenfrequenz bei 90° Phasenverschiebung zwischen Sendesignal und Empfangssignal. In Abhängigkeit von der jeweiligen Anwendung des Schwingsystems, beispielsweise bei der Schwingung im viskosen Medium in Abhängigkeit von der Viskosität, kann die Vorgabe einer anderen Phasenverschiebung p notwendig sein.

In Schritt 2 wird das Empfangssignal zu bestimmten ausgehend vom Sendesignal vorgegebenen Zeitpunkten abgetastet. In dieser Ausgestaltung weist die Amplitude des Empfangssignals gegenüber der Amplitude des Sendesignals keine Abschwächung auf. In diesem Fall wird das Empfangssignal zu den Zeitpunkten abgetastet, zu welchen es bei Vorliegen der vorgegebenen Phasenverschiebung p Nulldurchgänge aufweisen müsste. Es kann auch nur ein Nulldurchgang innerhalb einer Periodendauer abgetastet werden. In einer alternativen Ausgestaltung, insbesondere bei variierender Amplitude des Empfangssignals, wird zusätzlich das potentielle Maximum und/oder Minimum abgetastet.

In Schritt 3 werden die gemessenen Spannungswerte mit dem jeweiligen Sollwert verglichen und das Vorzeichen und die Höhe einer Abweichung bestimmt. Die Höhe der Abweichung ist hier durch die bekannte Amplitude bestimmbar. Bei variierender Amplitude dient hierzu der mindestens eine zusätzliche Abtastpunkt im potentiellen Maximum und/oder Minimum. Hieraus wird die vorliegende Phasenverschiebung $\rho_1$ bestimmt.

In Schritt 4 wird bestimmt, ob die vorliegende Phasenverschiebung $\rho_1$ mit der vorgegebenen Phasenverschiebung p übereinstimmt. Entsprechend des Ergebnisses dieses Vergleichs wird im nächsten Schritt die Frequenz des Sendesignals nachgeführt, d.h. verringert oder erhöht, falls die aktuell vorliegende Phasenverschiebung $\rho_1$ von der vorgegebenen Phasenverschiebung $\rho$ abweicht.

Falls die vorliegende Phasenverschiebung $\rho_1$ den Wert der vorgegebenen Phasenverschiebung $\rho$ unterschreitet, wird in Schritt 5a eine Erhöhung der Sendefrequenz vorgenommen. Falls die vorliegende Phasenverschiebung $\rho_1$ höher ist als die vorgegebene Phasenverschiebung p, wird in Schritt 5b eine Verringerung der Sendefrequenz vorgenommen. Da die vorliegende Phasenverschiebung $\rho_1$ bekannt ist, kann die Frequenz direkt um den entsprechend notwendigen Betrag nachgeführt werden, um die vorgegebene Phasenverschiebung p zu erhalten. Andernfalls, d.h. falls nur die Richtung der notwendigen Frequenzkorrektur bekannt ist, kann die Frequenz um einen festen Betrag nachgeführt werden. In diesem Fall wird die vorgegebene Phasenverschiebung p erst nach entsprechend vielen Durchgängen erreicht. Bevorzugt wird das Verfahren ohne Unterbrechung fortlaufend ab Schritt 2 wiederholt, sodass die Phase ständig geregelt wird.

### Bezugszeichenliste

SA      Sendesignal
SE      Empfangssignal
$\rho$       Vorgegebene Phasenverschiebung
$\rho_1, \rho_2$   Vorliegende Phasenverschiebung

### Patentansprüche

1.  Verfahren zur Anregung eines vibronischen Schwingsystems zur Bestimmung und/oder Überwachung mindestens einer Prozessgröße, mit einer schwingfähigen Einheit, mit einer elektromechanischen Wandlereinheit, und mit einer Regel-/Auswerteeinheit,
    wobei die schwingfähige Einheit von der elektromechanischen Wandlereinheit mittels eines elektrischen Sendesignals zu mechanischen Schwingungen angeregt wird,
    wobei Schwingungen der schwingfähigen Einheit von der elektromechanischen Wandlereinheit empfangen und in ein elektrisches Empfangssignal umgewandelt werden,
    wobei mittels der Regel-/Auswerteeinheit aus dem Empfangssignal das Sendesignal für die elektromechanische Wandlereinheit generiert wird,
    wobei die Frequenz des Sendesignals derart eingestellt wird, dass eine vorliegende Phasenverschiebung zwischen dem Sendesignal und dem Empfangssignal der elektromechanischen Wandlereinheit auf eine vorgegebene Phasenverschiebung (p) geregelt wird,
**dadurch gekennzeichnet,**
**dass** die Spannungswerte des Empfangssignals zu bestimmten ausgehend vom Sendesignals vorgegebenen diskreten Zeitpunkten abgetastet werden, dass jeder der abgetasteten Spannungswerte des Empfangssignals jeweils mit einem Sollwert verglichen wird, gegeben durch den Spannungswert des Empfangssignals zum jeweiligen vorgegebenen Zeitpunkt, wenn die vorgegebene Phasenverschiebung (p) vorliegt,
und **dass** im Falle einer Abweichung des abgetasteten Spannungswertes des Empfangssignals von dem Sollwert zumindest ausgehend von dem Vorzeichen der Abweichung die Frequenz des Sendesignals verringert oder erhöht wird.

2. Verfahren nach Anspruch 1,
**dadurch gekennzeichnet,**
**dass** die elektromechanische Wandlereinheit zu Beginn der Regelung mit einer Frequenz zu Schwingungen angeregt wird, bei welcher das Sendesignal zumindest näherungsweise die vorgegebene Phasenverschiebung (p) zu dem Empfangssignal aufweist.

3. Verfahren nach Anspruch 1 oder 2,
**dadurch gekennzeichnet,**
**dass** die Abweichung der vorliegenden Phasenverschiebung ($\rho_1$) von der vorgegebenen Phasenverschiebung (p) quantitativ erfasst wird und
**dass** die Frequenz entsprechend der quantitativen Abweichung erhöht oder verringert wird.

4. Verfahren nach einem der vorangehenden Ansprüche,
**dadurch gekennzeichnet,**
**dass** innerhalb einer Schwingungsperiode mindestens ein Spannungswert abgetastet wird.

5. Verfahren nach einem der vorangehenden Ansprüche,
**dadurch gekennzeichnet,**
**dass** das Empfangssignal zu Zeitpunkten abgetastet wird, zu welchen das Empfangssignal bei Vorliegen der vorgegebenen Phasenverschiebung (p) Nulldurchgänge aufweist.

6. Verfahren nach einem der vorangehenden Ansprüche,
**dadurch gekennzeichnet,**
**dass** das Empfangssignal zu Zeitpunkten abgetastet wird, zu welchen das Empfangssignal bei Vorliegen der vorgegebenen Phasenverschiebung (p) extremal ist.

7. Verfahren nach Anspruch 5 und 6,
**dadurch gekennzeichnet,**
**dass** der zu einem Zeitpunkt, zu welchem das Empfangssignal bei Vorliegen der vorgegebenen Phasenverschiebung (p) extremal ist, abgetastete Spannungswert mit dem zu einem Zeitpunkt, zu welchem das Empfangssignal bei Vorliegen der vorgegebenen Phasenverschiebung (p) einen Nulldurchgang aufweist, abgetasteten Spannungswert verglichen wird, und dass aus dem Vergleich bestimmt wird, wie die Frequenz nachgeregelt wird.

8. Vorrichtung zur Bestimmung und/oder Überwachung mindestens einer Prozessgröße,
mit einer schwingfähigen Einheit,
mit einer elektromechanischen Wandlereinheit, welche so ausgestaltet ist, dass sie die schwingfähige Einheit mittels eines elektrischen Sendesignals zu mechanischen Schwingungen anregt und Schwingungen von dieser empfängt und in ein elektrisches Empfangssignal umwandelt,
**dadurch gekennzeichnet,**
**dass** eine Regel-/Auswerteeinheit vorgesehen ist, welche ausgelegt ist zur Durchführung des Verfahrens nach Anspruch 1.

9. Vorrichtung nach Anspruch 8,
**gekennzeichnet dadurch,**
**dass** die elektromechanische Wandlereinheit ein piezoelektrischer Antrieb ist.

**Claims**

1. Procedure to excite a vibronic oscillation system for determining and/or monitoring at least one process variable, with a unit capable of oscillation, with an electromechanical converter unit, and with a control/evaluation unit,
wherein the unit capable of oscillation is excited to mechanical vibrations by the electromechanical converter via an electrical transmission signal,
wherein vibrations of the unit capable of oscillation are received by the electromechanical converter unit and converted to an electrical reception signal,
wherein the transmission signal for the electromechanical converter unit is generated from the reception signal by means of the control/evaluation unit,
wherein the frequency of the transmission signal is set in such a way that a phase shift between the transmission signal and the reception signal of the electromechanical converter is regulated to predefined phase shift (p), **characterized in that**
the voltage values of the reception signal are scanned at certain, predefined discrete times as a function of the transmission signal,
each of the scanned voltage values of the reception signal is compared in each case against a target value which is defined by the voltage value of the reception signal at the particular predefined point in time if the predefined phase shift (p) is present, and that in the event that the scanned voltage value of the reception signal deviates from the target value, the frequency of the transmission signal is reduced or increased at least as a function of the sign of the deviation.

**2.** Procedure as claimed in Claim 1,
**characterized in that**
at the start of regulation, the electromechanical converter unit is excited to oscillate at a frequency at which the transmission signal at least approximately presents the predefined phase shift (p) in relation to the reception signal.

**3.** Procedure as claimed in Claim 1 or 2,
**characterized in that**
the deviation of the actual phase shift (p1) from the predefined phase shift (p) is quantitatively measured and
**in that** the frequency is increased or decreased depending on the quantitative deviation.

**4.** Procedure as claimed in one of the previous claims,
**characterized in that**
at least one voltage value is scanned within an oscillation period.

**5.** Procedure as claimed in one of the previous claims,
**characterized in that**
the reception signal is scanned at times when the reception signal has zero crossings if the predefined phase shift (p) is present.

**6.** Procedure as claimed in one of the previous claims,
**characterized in that**
the reception signal is scanned at times when the reception signal is extremal if the predefined phase shift (p) is present.

**7.** Procedure as claimed in Claim 5 and 6,
**characterized in that**
the voltage value which is scanned at a time when the reception signal is extremal when the predefined phase shift (p) is present is compared against the voltage value which is scanned at a time when the reception signal has a zero crossing when the predefined phase shift (p) is present, and, on the basis of the comparison it is determined how the frequency is readjusted.

**8.** Unit designed to determine and/or monitor at least one process variable,
with a unit that is capable of oscillation,
with an electromechanical converter unit,
said converter unit being designed in such a way that it excites the unit capable of oscillation to mechanical oscillations by means of an electrical transmission signal and receives oscillations from said unit and converts them to an electrical reception signal,
**characterized in that**
a control/evaluation unit is provided which is designed to perform the procedure as claimed in Claim 1.

**9.** Unit as claimed in Claim 8,
**characterized in that**
the electromechanical converter unit is a piezoelectric drive.

**Revendications**

**1.** Procédé destiné à l'excitation d'un système vibronique destiné à la détermination et/ou la surveillance d'au moins une grandeur process, avec une unité apte à vibrer, avec une unité de convertisseur électromécanique et avec une unité de régulation / d'exploitation,
pour lequel l'unité apte à vibrer est excitée en vibrations par l'unité de convertisseur électromécanique au moyen d'un signal d'émission électrique,
pour lequel les vibrations de l'unité apte à vibrer sont reçues par l'unité de convertisseur électromécanique et converties en un signal de réception électrique,
pour lequel est généré à partir du signal de réception, au moyen de l'unité de régulation / d'exploitation, le signal d'émission pour l'unité de convertisseur électromécanique,
pour lequel la fréquence du signal d'émission est réglé de telle manière qu'un déphasage existant entre le signal d'émission et le signal de réception de l'unité de convertisseur électromécanique est réglé à un déphasage (p) prédéfini,
**caractérisé**
**en ce que** les valeurs de tension du signal de réception sont mesurées selon des instants discrets prédéfinis en fonction du signal d'émission,
**en ce que** chacune des valeurs de tension mesurées du signal de réception est comparée avec une valeur de consigne définie par la valeur de tension du signal de réception à chaque instant prédéfini, lorsque le déphasage (p) prédéfini est présent,
et **en ce qu'**en cas d'écart de la valeur de tension mesurée du signal de réception par rapport à la valeur de consigne, la fréquence du signal d'émission est diminuée ou augmentée, au moins en fonction du signe de l'écart.

**2.** Procédé selon la revendication 1,
**caractérisé**
**en ce que** l'unité de convertisseur électromécanique est excitée en vibrations, au début de la régulation, à une fréquence à laquelle le signal d'émission présente au moins approximativement le déphasage (p) prédéfini par rapport au signal de réception.

3. Procédé selon la revendication 1 ou 2, **caractérisé en ce que** l'écart du déphasage (p1) existant par rapport au déphasage (p) prédéfini est mesuré quantitativement et **en ce que** la fréquence est augmentée ou diminuée en fonction de l'écart quantitatif.

4. Procédé selon l'une des revendications précédentes, **caractérisé en ce qu'**est mesurée au moins une valeur de tension au sein d'une période de vibration.

5. Procédé selon l'une des revendications précédentes, **caractérisé en ce que** le signal de réception est mesuré à des instants auxquels le signal de réception présente des passages par zéro en présence du déphasage (p) prédéfini.

6. Procédé selon l'une des revendications précédentes, **caractérisé en ce que** le signal de réception est mesuré à des instants auxquels le signal de réception présente un extrême en présence du déphasage (p) prédéfini.

7. Procédé selon les revendications 5 et 6, **caractérisé en ce que** la valeur de tension mesurée en un instant auquel le signal de réception présente un extrême en présence du déphasage (p) prédéfini est comparée avec une valeur de tension mesurée en un instant auquel le signal de réception présente un passage par zéro en présence du déphasage (p) prédéfini, et **en ce qu'**est déterminée, à partir de la comparaison, la manière dont la fréquence est réajustée.

8. Dispositif destiné à la détermination et/ou la surveillance d'au moins une grandeur process, avec une unité apte à vibrer, avec une unité de convertisseur électromécanique, laquelle est conçue de telle manière à exciter en vibrations mécaniques l'unité apte à vibrer au moyen d'un signal d'émission électrique, et à recevoir de cette unité les vibrations et à les convertir en un signal de réception électrique, **caractérisé en ce qu'**est prévue une unité de régulation / d'exploitation, laquelle est conçue pour la réalisation du procédé selon la revendication 1.

9. Dispositif selon la revendication 8, **caractérisé en ce que** l'unité de convertisseur électromécanique est un entraînement piézoélectrique.

Fig. 1a

Fig. 1b

Fig. 1c

SA

SE ($\rho_1$)

SE ($\rho_2$)

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009026685
- DE 102009028022